# EUROPÄISCHE PATENTSCHRIFT

(11) **EP 3 571 766 B1**
(45) Veröffentlichungstag und Bekanntmachung des Hinweises auf die Patenterteilung: **11.10.2023**
(21) Anmeldenummer: 18710365.0
(22) Anmeldetag: 27.02.2018
(51) Int. Cl.: H03K 17/0814, H03K 17/16

(54) **SCHALTVORRICHTUNG ZUM AUFTRENNEN EINES STROMPFADS**
SWITCHING DEVICE FOR SEPARATING A CURRENT PATH
DISPOSITIF DE COMMUTATION DESTINÉ À SÉPARER UN CHEMIN DE COURANT

(30) Priorität: 28.02.2017 EP 17158392
(43) Veröffentlichungstag der Anmeldung: 27.11.2019
(73) Patentinhaber: Siemens Energy Global GmbH & Co. KG, 81739 München (DE)
(72) Erfinder: RUPP, Jürgen, 91056 Erlangen (DE)
(86) Internationale Anmeldenummer: PCT/EP2018/054775
(87) Internationale Veröffentlichungsnummer: WO 2018/158233

(56) Entgegenhaltungen:
- EP-A1- 3 032 733
- WO-A2-2011/095212
- DE-A1- 10 350 361

## Beschreibung

Die Erfindung betrifft eine Schaltvorrichtung zum Auftrennen eines quell- und lastseitige Induktivitäten umfassenden Strompfads eines Gleichspannungsnetzes.

Eine Schaltvorrichtung, die zum Auftrennen eines quell- und lastseitige Induktivitäten umfassenden Strompfads eines Gleichspannungsnetzes vorgesehen ist, muss die Rückspeisung oder den Abbau von Energie aus dem Gleichspannungsnetz handhaben können.

Werden, wie bei dem sog. ABB-Schalter, mechanische Schalter eingesetzt, so besteht die Gefahr der Entstehung eines Lichtbogens, sofern nicht sichergestellt werden kann, dass das Auftrennen des Strompfads im Nulldurchgang des Stroms erfolgt. Ein solches mechanisches Schaltelement muss daher durch eine aufwändige Beschaltung, z.B. durch das Vorsehen mehrerer Halbleiterschaltelemente und Varistoren als Überspannungsbegrenzer, geschützt werden. Dazu kann beispielsweise der im Hauptstromzweig liegende, schnell schaltende mechanische Schalter mit einem Halbleiterschaltelement, das im Durchlassfall einen geringen Spannungsabfall aufweist, verschaltet werden. Die Aufgabe dieses Halbleiterschaltelements beim Auftrennen des Lastpfads besteht darin, bei der Abschaltung einen Spannungsabfall zu erzeugen, damit der Strom in einen zu dieser Anordnung parallel geschalteten Hauptschalter geführt werden kann. Dieser Hauptschalter besteht aus einer Serienschaltung mehrerer Halbleiterschaltelemente, zu deren Überspannungsschutz jeweils ein Varistor parallel geschaltet ist. Fließt nun der Strom im Wesentlichen über den parallelen Pfad, so kann der schnelle mechanische Schalter ausgeschaltet werden, ohne dass ein Lichtbogen entsteht. Nachteil dieser Schaltvorrichtung ist die Komplexität aufgrund der Vielzahl an benötigten Halbleiterschaltelementen und Varistoren, wobei letztere sehr teuer und schwer sind.

Es sind auch Schaltvorrichtungen bekannt, die ausschließlich steuerbare Halbleiterschaltelemente, z.B. IGBTs umfassen. Bei dieser Variante können beispielsweise zwei Halbleiterschaltelemente anti-seriell in den Lastpfad geschaltet werden. Ohne weitere Maßnahmen kann diese Schaltvorrichtung jedoch nur in Gleichspannungsnetzen eingesetzt werden, welche keine große Induktivitäten aufweisen. Zudem werden spannungsbegrenzende Elemente, wie z.B. Varistoren und dergleichen, erforderlich, welche jedoch aus Kostengründen ungern verwendet werden.

Weiterhin sind sogenannte Hybridschalter bekannt, wie der sogenannte Marquardt-Schalter, welcher beim Abschalten einen künstlichen Stromdurchgang Null erzeugt, indem ein Gegenstrom aufgeprägt wird. Da im Normalbetrieb kein Halbleiterschaltelement im Strompfad liegt, können die Verluste dieses Hybridschalters sehr klein gehalten werden. Die Schaltgeschwindigkeit hängt von einem in dem Hybridschalter vorgesehenen mechanischen Schaltelement ab.

In der WO 2011/095212 A2 ist ein Schaltmodul offenbart, das zur Verwendung in einem Mittel- oder Hochspannungs-Gleichstromunterbrecher oder einem Gleichstrombegrenzer vorgesehen ist. Es umfasst mindestens ein Leistungshalbleiter-Schaltelement, eine Gate-Einheit, die so angeordnet ist, dass sie das mindestens eine Leistungshalbleiter-Schaltelement entsprechend einem Schaltsteuersignal ein- bzw. ausschaltet, und einen Energiespeicherkondensator, der so angeordnet ist, dass er einem Stromversorgungseingang der Gate-Einheit Strom zuführt.

Ein Problem der oben beschriebenen Schaltvorrichtungstypen ist die in den Netzinduktivitäten abzubauende Energie. Beim schnellen Abschalten bauen sich hohe Spannungen auf, die über eine Schutzbeschaltung abgebaut werden müssen, um Schäden an den Komponenten der Schaltvorrichtung zu verhindern. Keine der oben genannten Varianten löst dieses Problem in zufriedenstellender Weise hinsichtlich technischer Funktionalität und Wirtschaftlichkeit.

Es ist Aufgabe der Erfindung, eine Schaltvorrichtung zum Auftrennen eines quell- und lastseitige Induktivitäten umfassenden Strompfads eines Gleichspannungsnetzes anzugeben, welche baulich und/oder funktionell verbessert ist. Insbesondere soll die Schaltvorrichtung mit geringeren Kosten bereitstellbarer sein.

Diese Aufgabe wird gelöst durch eine Schaltvorrichtung gemäß den Merkmalen des Patentanspruchs 1. Vorteilhafte Ausgestaltungen ergeben sich aus den abhängigen Ansprüchen.

Es wird eine Schaltvorrichtung zum Auftrennen eines quell- und lastseitige Induktivitäten umfassenden Strompfads eines Gleichspannungsnetzes vorgeschlagen, die zumindest zwei in Serie verschaltete Schaltmodule umfasst. Jedes der Schaltmodule umfasst zumindest ein steuerbares Halbleiterschaltelement, dem eine Serienschaltung aus einem Widerstand und einem Kondensator parallel geschaltet ist, wobei die Schaltvorrichtung eingerichtet ist, die steuerbaren Halbleiterschaltelemente im Betrieb der Schaltvorrichtung zum Auftrennen des Strompfads bis zum Abbau der in den Induktivitäten gespeicherten Energie jeweils abwechselnd ein- und wieder auszuschalten, wobei Halbleiterschaltelemente unterschiedlicher Schaltmodule zu unterschiedlichen Zeitpunkten ein- und ausgeschaltet werden, sodass sich zu einem gegebenen Zeitpunkt zumindest ein Schaltmodul in einem sperrenden Zustand befindet.

Eine derartige Schaltvorrichtung ermöglicht einen "weichen" Abschaltvorgang, bei dem der Stromfluss in dem Strompfad nicht abrupt, sondern rampenförmig abgebaut wird. Durch wenigstens eines der zumindest zwei Schaltmodule wird eine Gegenspannung im Strompfad aufgebaut. Dies wird durch einen Betrieb des jeweiligen Halbleiterschalterelements der Schaltmodule im getakteten Bereich ermöglicht. Damit wird die hohe Verlustleistung im Abschaltfall nicht in dem Halbleiterschaltelement der jeweiligen Schaltmodule umgesetzt, sondern überwiegend in dem Widerstand der jeweiligen Schaltmodule. Die Schaltvorrichtung kann dadurch auf spannungsbegrenzende Bauelemente, wie Varistoren, verzichten, die teuer, schwer und bauraumintensiv sind. Das Halbleiterschaltelement in den jeweiligen Schaltmodulen übernimmt dabei die Rolle des Bremschoppers. Gleichzeitig kann der jeweilige Kondensator der Schaltmodule klein dimensioniert werden, da er nicht die gesamte, in den quell- und lastseitigen Induktivitäten gespeicherte Energie aufnehmen muss, sondern lediglich einen kleinen Teil aufgrund des getakteten Betriebs des Halbleiterschaltelements der betreffenden Schaltmodule. Die abzubauende Gesamtenergie ist damit nicht durch das Halbleiterschaltelement der betreffenden Schaltmodule begrenzt. Lediglich dauert der Abschaltvorgang bei größeren quell- und lastseitigen Induktivitäten länger.

Ein Vorteilhafter Einsatz der Schaltvorrichtung ist insbesondere in Schiffen möglich, dort insbesondere in Mittelspannungs-DC-Netzen. Ein schneller und sicherer DC-Schalter ermöglicht dort eine sichere Trennung von DC-Zonen, beispielsweise bei Flutung oder anderen Abschaltszenarien. Generell gilt dies auch im Betrieb von anderen Inselnetzen, bei denen verschiedene Zonen sicher und schnell trennbar bleiben müssen.

Eine zweckmäßige Ausgestaltung gemäß einer ersten Variante sieht vor, dass die Parallelschaltung aus dem zumindest einen steuerbaren Schaltelement und der Serienschaltung aus dem Widerstand und dem Kondensator zwischen einem ersten Schaltmodulanschluss und einem zweiten Schaltmodulanschluss des jeweiligen Schaltmoduls verschaltet ist. Eine Mehrzahl an seriell verschalteten Schaltmodulen kann dann derart verschaltet werden, dass ein erster Schaltmodulanschluss eines Schaltmoduls mit dem zweiten Schaltmodulanschluss eines vorhergehenden Schaltmoduls verschaltet ist. Der erste Schaltmodulanschluss eines ersten Schaltmoduls ist über eine quellseitige Induktivität mit einer Gleichspannungsquelle, ein zweiter Schaltmodulanschluss eines letzten Schaltmoduls der Mehrzahl an Schaltmodulen über eine lastseitige Induktivität mit einer Last verschaltet. Ein derartiges Schaltmodul, bei dem zumindest ein steuerbares Halbleiterschaltelement, ein Widerstand und ein Kondensator vorgesehen sind, kommt mit einer minimalen Anzahl an Bauelementen aus.

Eine weitere zweckmäßige Ausgestaltung gemäß einer zweiten Variante sieht vor, dass die Parallelschaltung aus genau einem steuerbaren Halbleiterschaltelement und der Serienschaltung aus dem Widerstand und dem Kondensator (sog. Grundmodul) zwischen einem ersten Gleichrichtanschluss und einem zweiten Gleichrichtanschluss einer Gleichrichterbrücke des jeweiligen Schaltmoduls verschaltet ist. Der erste Gleichrichtanschluss ist ein erster Knotenpunkt der Gleichrichterbrücke, an den Kathodenanschlüsse zweier Gleichrichtelemente miteinander verschaltet sind. Der zweite Gleichrichtanschluss ist ein zweiter Knotenpunkt der Gleichrichterbrücke, an dem Anodenanschlüsse zweier weiterer Gleichrichtelemente miteinander verschaltet sind. Wird ein unidirektionales Grundmodul, d.h. ein Schaltmodul, das lediglich ein einziges Halbleiterschaltelement umfasst, in der Gleichrichterbrücke vorgesehen, so kann das Schaltmodul für beide Stromrichtungen genutzt werden. Eine Stromumkehr wird durch die Gleichrichterbrücke, welche im einfachsten Fall eine Diodenbrücke ist, realisiert.

Gemäß dieser Ausgestaltung kann eine beliebige Anzahl an Schaltmodulen in Reihe verschaltet werden. Die Reihenschaltung erfolgt dabei derart, dass ein dritter Gleichrichtanschluss eines Schaltmoduls mit einem vierten Gleichrichtanschluss eines vorhergehenden Schaltmoduls verschaltet wird. Der dritte Gleichrichtanschluss ist ein dritter Knotenpunkt der Gleichrichterbrücke, an dem ein Kathodenanschluss eines Gleichrichtelements mit einem Anodenanschluss eines anderen Gleichrichtelements miteinander verschaltet ist. In entsprechender Weise ist der vierte Gleichrichtanschluss ein vierter Knotenpunkt der Gleichrichterbrücke, an dem ein Kathodenanschluss eines Gleichrichtelements mit einem Kathodenanschluss eines anderen Gleichrichtelements miteinander verschaltet ist.

Eine weitere zweckmäßige Ausgestaltung sieht vor, dass im Betrieb der Schaltvorrichtung zum Auftrennen des Strompfads bis zum Abbau der in den quell- und lastseitigen Induktivitäten gespeicherten Energie zu einem gegebenen Zeitpunkt das steuerbare Halbleiterschaltelement zumindest eines Schaltmoduls sperrend geschaltet ist. Somit kann verhindert werden, dass z.B. bei einem Auftrennvorgang aufgrund eines lastseitigen Kurzschlusses sich der Kurzschlussstrom wieder über die Schaltvorrichtung aufbauen kann.

Eine weitere zweckmäßige Ausgestaltung sieht vor, dass im Betrieb der Schaltvorrichtung zum Auftrennen des Strompfads bis zum Abbau der in den Induktivitäten gespeicherten Energie zu einem gegebenen Zeitpunkt das steuerbare Halbleiterschaltelement einer ersten Teilanzahl von Schaltmodulen sperrend geschaltet und eine zweite Teilanzahl von Schaltmodulen leitend geschaltet sind. Wie viele der Gesamtzahl der Schaltmodule leitend und wie viele sperrend geschaltet sind, kann durch eine übergeordnete Steuervorrichtung koordiniert werden oder aufgrund der sich in den jeweiligen Schaltmodulen einstellenden Spannungshöhen festgelegt sein.

Eine weitere zweckmäßige Ausgestaltung sieht vor, dass im Betrieb der Schaltvorrichtung zum Auftrennen des Strompfads bis zum Abbau der in den Induktivitäten gespeicherten Energie das steuerbare Halbleiterschaltelement des- oder derjenigen Schaltmodule leitend geschaltet wird, über dessen oder deren Kondensator die Spannung einen vorgegebenen oberen Schwellwert erreicht. Beim sperrend Schalten der Schaltvorrichtung ist zu einem gegebenen Zeitpunkt zumindest ein Schaltmodul sperrend geschaltet. Anders ausgedrückt, das steuerbare Halbleiterschaltelement des betreffenden Schaltmoduls ist sperrend geschaltet. Damit kann der Strom in diesem Schaltmodul nur noch über den parallelen Pfad des RC-Glieds weiterflie-ßen. Der Kondensator des RC-Glieds lädt sich dadurch auf, bis die Spannung den vorgegeben oberen Schwellwert erreicht. Anschließend wird das steuerbare Halbleiterschaltelement dieses Schaltmoduls wieder leitend geschaltet, so dass sich der Kondensator über den seriell verschalteten Widerstand entladen kann.

Eine weitere zweckmäßige Ausgestaltung sieht vor, dass im Betrieb der Schaltvorrichtung zum Auftrennen des Strompfads bis zum Abbau der in den Induktivitäten gespeicherten Energie das steuerbare Halbleiterschaltelement des- oder derjenigen Schaltmodule sperrend geschaltet wird, über dessen oder deren Kondensator die Spannung einen vorgegeben unteren Schwellwert erreicht. Sobald der untere Schwellwert erreicht ist, wird das steuerbare Halbleiterschaltelement des betreffenden Schaltmoduls wieder leitend geschaltet. Erfolgt die Lasttrennung aufgrund eines Kurzschlusses, so wird durch dieses Vorgehen zwar kurzzeitig wieder auf diesen Kurzschluss geschaltet. Da dies aber nur für kurze Zeit erfolgt, wird der Strom im Mittel abgebaut, da die quell- und lastseitigen Induktivitäten einen zu schnellen Anstieg verhindern.

Eine weitere zweckmäßige Ausgestaltung sieht vor, dass im Betrieb der Schaltvorrichtung zum Auftrennen des Strompfads bis zum Abbau der in den Induktivitäten gespeicherten Energie das steuerbare Halbleiterschaltelement des- oder derjenigen Schaltmodule dauerhaft sperrend geschaltet wird, wenn über dessen oder deren Kondensator die Spannung den vorgegeben oberen Schwellwert nicht mehr erreicht. Die Spannung kann dadurch mit eigener Resonanz ausschwingen.

Eine weitere Ausgestaltung sieht vor, dass im Betrieb der Schaltvorrichtung zum Auftrennen des Strompfads bis zum Abbau der in den Induktivitäten gespeicherten Energie zu einem gegebenen Zeitpunkt das steuerbare Halbleiterschaltelement des Schaltmoduls leitend geschaltet wird, über deren Kondensator die höchste Spannung im Vergleich zu den Spannungen der Kondensatoren der übrigen Schaltmodule anliegt. Gemäß dieser Ausgestaltung wird zum Ausschalten eines steuerbaren Halbleiterschaltelements kein oberer Schwellwert ermittelt. Vielmehr werden die Spannungen über den Kondensatoren aller Schaltmodule separat ermittelt und miteinander verglichen. Das steuerbare Halbleiterschaltelement desjenigen Schaltmoduls, über dessen Kondensator die höchste Spannung abfällt, wird dann leitend geschaltet. Hierdurch ist sichergestellt, dass keine Überlastung des steuerbaren Halbleiterschaltelements eines jeweiligen Schaltmoduls, auch bei hohen Überspannungen auftreten kann. Hierdurch ergibt sich auch eine gewisse Zufälligkeit, in welchem Schaltzustand sich welches Schaltmodul zu einem gegebenen Schaltzeitpunkt befindet.

Eine weitere zweckmäßige Ausgestaltung sieht vor, dass in dem Pfad des steuerbaren Halbleiterschaltelements eines jeweiligen Schaltmoduls ein weiteres steuerbares Halbleiterschaltelement anti-seriell zu dem steuerbaren Halbleiterschaltelement verschaltet ist. Dadurch wird ein bidirektional betreibbares Schaltmodul bereitgestellt, so dass im Ergebnis die Schaltvorrichtung den Strompfad, unabhängig von der vorherrschenden Stromrichtung, abschalten kann.

Eine weitere zweckmäßige Ausgestaltung sieht vor, dass das steuerbare Halbleiterschaltelement ein abschaltbares Halbleiterschaltelement ist. Insbesondere können als steuerbare Halbleiterschaltelemente ein IGBT, ein MOSFET, ein IGCT oder ein Thyristor mit einer Abschalteinrichtung (sog. Löschkreis) eingesetzt werden.

Die beschriebene Schaltvorrichtung ist insbesondere für die Verwendung in einem Gleichspannungsnetz mit einer Spannung von mehr als 1000 V vorgesehen. Insbesondere lässt sich die Schaltvorrichtung in Hochspannungsgleichstromübertragungsleitungen einsetzen. In Abhängigkeit der in dem Gleichspannungsnetz vorherrschenden Spannung muss dann eine geeignete entsprechende Anzahl an Schaltmodulen der Schaltvorrichtung gewählt werden. Je höher die zu beherrschende Spannung in dem Gleichspannungsnetz ist, desto größer wird - gleiche Halbleiterschaltelemente vorausgesetzt - die Anzahl der Schaltmodule gewählt. Bei Gleichspannungsnetzen im Mittelspannungsbereich können insbesondere IGBTs oder MOSFETs zum Einsatz kommen. Bei noch höheren Spannungen kommen insbesondere Thyristoren mit einer Abschalteinrichtung oder IGCTs zum Einsatz. Eine weitere Ausgestaltung sieht vor, dass die Schaltvorrichtung der hier beschriebenen Art als Kurzschlussfester Leistungsschalter verwendet wird.

Die Erfindung wird nachfolgend näher anhand von Ausführungsbeispielen in der Zeichnung erläutert. Es zeigen:
- Fig. 1: ein elektrisches Ersatzschaltbild, das den Aufbau eines einzelnen unidirektionalen Schaltmoduls für eine erfindungsgemäße Schaltvorrichtung zeigt;
- Fig. 2: ein elektrisches Ersatzschaltbild einer seriellen Verschaltung von drei in Fig. 1 gezeigten Schaltmodulen;
- Fig. 3: ein elektrisches Ersatzschaltbild einer erfindungsgemäßen Schaltvorrichtung in einem Gleichspannungsnetz mit quell- und lastseitigen Induktivitäten;
- Fig. 4: ein Diagramm, das den zeitlichen Verlauf von Spannung und Strom bei einem Auftrennvorgang der erfindungsgemäßen Schaltvorrichtung mit zwei Schaltmodulen zeigt;
- Fig. 5: ein Diagramm, das den zeitlichen Verlauf der über zwei seriell miteinander verschalteten Schaltmodulen anfallenden Spannung sowie der über der Schaltvorrichtung abfallenden Gesamtspannung zeigt;
- Fig. 6: ein Diagramm, das den zeitlichen Verlauf von Spannung und Strom aufgrund der durch die erfindungsgemäße Schaltvorrichtung erzeugten Gegenspannung illustriert;
- Fig. 7: ein Diagramm, das den zeitlichen Verlauf der Spannungen von drei seriell miteinander verschalteten Schaltmodulen sowie die sich daraus ergebende Gesamtspannung der Schaltvorrichtung zeigt;
- Fig. 8: ein Ausführungsbeispiel eines erfindungsgemäßen bidirektionalen Schaltmoduls; und
- Fig. 9: ein elektrisches Ersatzschaltbild einer erfindungsgemäßen Schaltvorrichtung in einem Gleichspannungsnetz, bei dem die Schaltvorrichtung aus zwei abgewandelten Schaltmodulen mit einem Brückengleichrichter besteht.

In der nachfolgenden Beschreibung sind gleiche Elemente mit gleichen Bezugszeichen versehen.

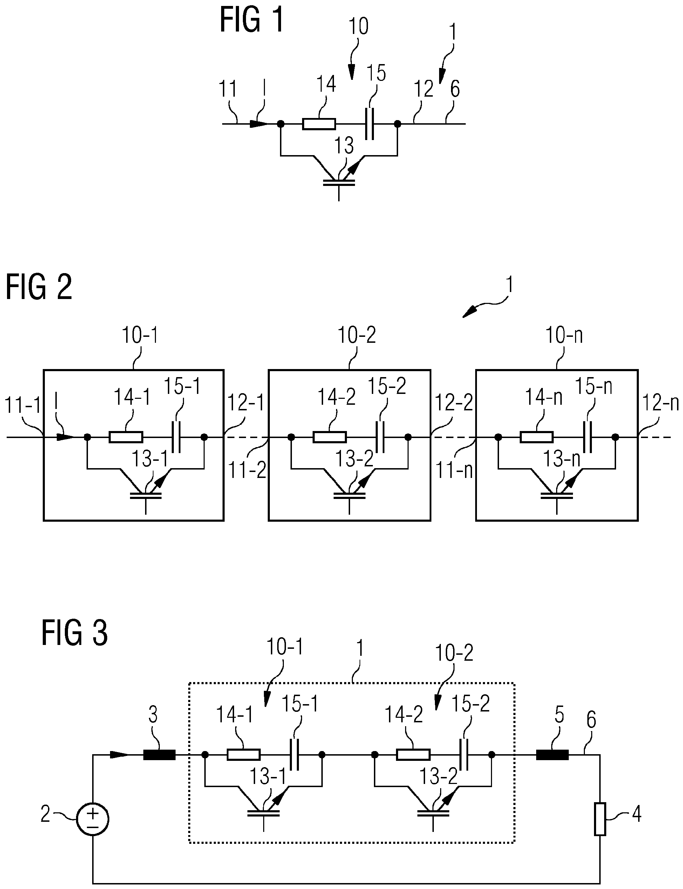

Fig. 1 zeigt den schematischen Aufbau eines Schaltmoduls 10 einer erfindungsgemäßen Schaltvorrichtung 1 zum Auftrennen eines quell- und lastseitige Induktivitäten umfassenden Strompfads 6. Das Schaltmodul 10 umfasst ein steuerbares Halbleiterschaltelement 13. Das steuerbare Halbleiterschaltelement 13 kann ein IGBT, ein MOSFET, ein IGCT oder ein Thyristor mit einer Abschaltvorrichtung sein. Die Lastanschlüsse des steuerbaren Halbleiterschaltelements 13 sind zwischen einem ersten Schaltmodulanschluss 11 und einem zweiten Schaltmodulanschluss 12 verschaltet. Zwischen dem ersten und dem zweiten Schaltmodulanschluss 11, 12 ist ferner eine Reihenschaltung aus einem Widerstand 14 und einem Kondensator 15 angeordnet. Mit anderen Worten ist ein aus dem Widerstand 14 und dem Kondensator 15 gebildetes RC-Glied parallel zu den Lastanschlüssen des steuerbaren Schaltelements 13 geschaltet.

Die prinzipielle Funktionsweise eines solchen einzelnen Schaltmoduls der erfindungsgemäßen Schaltvorrichtung 1 ist wie folgt: Soll die Schaltvorrichtung 1 Strom führen, so ist das steuerbare Halbleiterschaltelement 13 leitend geschaltet.

Sobald der Strompfad 6 mit Hilfe der Schaltvorrichtung 1 aufgetrennt werden soll, wird das steuerbare Halbleiterschaltelement 13 durch eine in den Figuren nicht gezeigte Steuervorrichtung sperrend geschaltet. Dadurch kann der in dem Strompfad 6 fließende Strom I nur noch über das aus dem Widerstand 14 und dem Kondensator 15 gebildete RC-Glied weiter fließen. Der Kondensator 15 lädt sich infolge des in ihn fließenden Stroms I auf, bis ein vorgegebener oberer Schwellwert der über ihm abfallenden Spannung erreicht ist. Hierzu kann eine entsprechende Messvorrichtung (nicht dargestellt) in dem Schaltmodul 10 vorgesehen sein. Sobald der vorgegebene obere Schwellwert erreicht ist, wird das steuerbare Halbleiterschaltelement 13 wieder leitend geschaltet. Dadurch kann sich der Kondensator 15 über den Widerstand 14 entladen. Sobald ein vorgegebener unterer Schwellwert der über dem Kondensator 15 abfallenden Spannung erreicht ist, wird das steuerbare Halbleiterschaltelement 13 mittels seiner Steuervorrichtung wieder leitend geschaltet.

Erfolgt die Auftrennung des Strompfades 6 beispielsweise aufgrund eines in dem Gleichspannungsnetz auftretenden Kurzschlusses, so wird durch das Wiedereinschalten (leitend Schalten des steuerbaren Halbleiterschaltelements 13) es dem Kurzschlussstrom ermöglicht wieder durch das Schaltmodul 10 zu fließen. Da die Einschaltdauer des steuerbaren Halbleiterschaltelements 13 jedoch sehr kurz ist, wird der in dem Strompfad 6 fließende Strom I im Mittel abgebaut, weil die in Fig. 1 nicht gezeigten quell- und lastseitigen Induktivitäten 3 bzw. 5 (vergl. Fig. 3) einen zu schnellen Anstieg des Stroms verhindern.

Würde die Schaltvorrichtung 1 lediglich ein einziges Schaltmodul 1, wie in Fig. 1 dargestellt, umfassen, so können lediglich Spannungen beherrscht werden, die kleiner sind als die Maximalspannung des steuerbaren Halbleiterschaltelements 13. Bei größeren auftretenden Spannungen in Folge eines schnellen Abschaltvorgangs und dem Auftreten einer Überspannung aufgrund der in dem Strompfad vorhandenen Induktivitäten, könnte das steuerbare Halbleiterschaltelement 13 zerstört werden. Das Vorsehen eines einzigen Schaltmoduls 10 in der Schaltvorrichtung 1 ist grundsätzlich möglich, jedoch nur dann zweckmäßig, wenn das Gleichspannungsnetz hohe Impedanzen aufweist.

Um mit Hilfe der vorgeschlagenen Schaltvorrichtung 1 zum Auftrennen eines Strompfands eines Gleichspannungsnetzes mit höheren Spannungen realisieren zu können, ist daher gemäß Fig. 2 das serielle Verschalten einer Mehrzahl an wie in Fig. 1 gezeigten Schaltmodulen vorgesehen.

Fig. 2 zeigt ein elektrisches Ersatzschaltbild einer seriellen Verschaltung von n Schaltmodulen 10-1, 10-2, ..., 10-n (allgemein: 10-i, wobei i = 1 bis n). Jedes der Schaltmodule 10-i ist in der wie in Fig. 1 beschriebenen Weise aufgebaut. Die serielle Verschaltung der Schaltmodule 10-i erfolgt dabei derart, dass der zweite Schaltmodulanschluss 12-1 des ersten Schaltmoduls 10-1 mit dem ersten Schaltmodulanschluss 11-2 des nachfolgenden Schaltmoduls 10-2 verbunden ist, und so weiter. Der erste Schaltmodulanschluss 11-1 des ersten Schaltmoduls 10-1 ist, wie in Fig. 3 gezeigt, über eine quellseitige Induktivität 3 mit einer Gleichspannungsquelle 2 verbunden. Bei der Gleichspannungsquelle 2 kann es sich beispielsweise um eine Energieerzeugungseinheit, z.B. eine Photovoltaikanlage, ein Speichersystem, ein Batterieladegerät, eine Windenergieanlage, einen Gleichrichter und dergleichen handeln. Der zweite Schaltmodulanschluss 12-n des letzten Schaltmoduls 10-n ist, wie in Fig. 3 gezeigt, über eine lastseitige Induktivität 6 mit einer Last 4 verschaltet. Bei der Last 4 kann es sich beispielsweise um einen Antrieb eines Gleichspannungsnetzes o.ä. handeln.

Fig. 3 zeigt das elektrische Ersatzschaltbild einer erfindungsgemäßen Schaltvorrichtung 1, welche aus zwei seriell miteinander verschalteten Schaltmodulen 10-1 und 10-2 besteht, welche jeweils wie in Fig. 1 beschrieben, aufgebaut sind. Die Schaltvorrichtung 1 ist über die bereits erwähnte quellseitige Induktivität 3 mit der Gleichspannungsquelle 2 verbunden. Ausgangsseitig ist die Schaltvorrichtung 1 über die lastseitige Induktivität 5 mit der Last 4 verbunden. Die quell- und lastseitigen Induktivitäten 3, 5 müssen nicht zwingend physikalische Komponenten des Gleichspannungsnetzes darstellen. Die quell- und lastseitigen Induktivitäten 3, 5 können auch Leitungsinduktivitäten sein.

Die Funktionsweise der in Fig. 3 gezeigten Schaltvorrichtung ist wie folgt: Wenn die Last 4 aus der Gleichspannungsquelle 2 mit Strom versorgt werden soll, sind die steuerbaren Halbleiterschaltelemente 13-1, 13-2 (allgemein: 13-i, i = 1 bis 2) der Schaltmodule 10-1, 10-2 (allgemein: 10-i, i = 1 bis 2) leitend geschaltet. Sobald der Strompfad 6, z.B. aufgrund eines lastseitigen Kurzschlusses aufgetrennt werden soll, werden zunächst beide steuerbaren Halbleiterschaltelemente 13-i sperrend geschaltet, so dass der Strom I nur noch über die beiden RC-Glieder der Schaltmodule 10-i fließen kann. Die Kondensatoren 15-1, 15-2 (allgemein: 15-i, i = 1 bis 2) laden sich auf, bis ein jeweiliger vorgegebener oberer Schwellwert erreicht ist. Der vorgegebene obere Schwellwert kann für beide Kondensatoren 15-i gleich oder unterschiedlich gewählt sein. Zunächst wird eines der steuerbaren Halbleiterschaltelemente 13-1 oder 13-2 des Schaltmoduls 10-1 oder 10-2 wieder leitend geschaltet, so dass sich der zugeordnete Kondensator 15-1 oder 15-2 über den seriellen Widerstand 14-1 bzw. 14-2 entlädt. Sobald ein vorgegebener unterer Schwellwert erreicht ist, wird das entsprechende steuerbare Halbleiterschaltelement wieder sperrend geschaltet. Gleichzeitig oder zeitversetzt kurz danach wird das andere steuerbare Halbleiterschaltelement 13-2 oder 13-1 leitend geschaltet, wenn sein vorgegebener oberer Schwellwert erreicht ist. Auf diese Weise werden die beiden steuerbaren Halbleiterschaltelemente 13-1, 13-2 abwechselnd leitend geschaltet und damit sichergestellt, dass über beiden steuerbaren Halbleiterschaltelementen 13-i zusammen eine Summenspannung U_{ges} liegt, mit der der Stromfluss und damit die in den Induktivitäten 3, 5 gespeicherte Energie abgebaut wird.

Anders als bei der Verwendung eines einzigen Schaltmoduls liegt bei einer Mehrzahl von Schaltmodulen immer eine Gegenspannung (d.h. eine entgegen der Spannungsrichtung der Gleichspannungsquelle 2 gerichtete Spannung) im Gleichspannungsnetz an. Wenn die Anzahl n der in Serie verschalteten Schaltmodule sehr groß ist, fällt das kurzzeitige Kurzschlie-ßen eines Schaltmoduls kaum ins Gewicht, wodurch sich der Strom allmählich abbaut.

Sobald die vorgegebene obere Schaltschwelle in allen steuerbaren Halbleiterschaltelementen 13-i nicht mehr erreicht wird, bleiben alle steuerbaren Halbleiterschaltelemente 13-i der Schaltmodule 10-i dauerhaft gesperrt. Die Spannung im Gleichspannungsnetz schwingt dann mit Eigenresonanz aus.

Das beschriebene Vorgehen, wird unabhängig davon, wie groß die Anzahl n der in Reihe verschalteten Schaltmodule ist, in entsprechender Weise durchgeführt. Welche der steuerbaren Halbleiterschaltelemente 13-i zu einem gegebenen Zeitpunkt sperrend und welche anderen steuerbaren Halbleiterschaltelement 13-i leitend geschaltet sind, kann entweder unter gezielter Steuerung der erwähnten, jedoch nicht gezeigten Steuereinheit erfolgen. Ebenso kann durch die geeignete, unterschiedliche Wahl jeweiliger oberer Schaltschwellen das zeitliche Verhalten des Ein- und Ausschaltens des zugeordneten steuerbaren Halbleiterschaltelements beeinflusst werden.

In einer anderen Alternative kann die über den jeweiligen Kondensatoren 15-i anliegende Spannung durch entsprechende Messmittel (nicht gezeigt) überwacht werden. Dabei wird das dem Kondensator, bei dem die höchste Spannung anliegt, zugeordnete steuerbare Halbleiterschaltelement leitend geschaltet, bis der vorgegebene untere Schwellwert erreicht ist. Da zu unterschiedlichen Zeitpunkten immer unterschiedliche Schaltmodule bzw. deren Kondensatoren eine höchste Spannung aufweisen, ergibt sich ein mehr oder minder zufälliges Ein- und Ausschalten der steuerbaren Halbleiterschaltelemente 13-i der Schaltmodule 10-i.

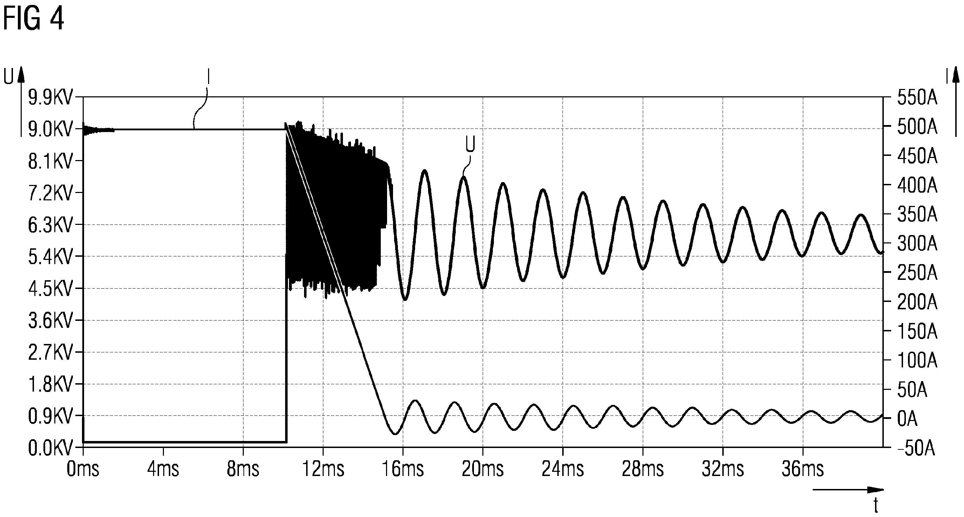

Fig. 4 zeigt im zeitlichen Verlauf der Spannung U und des Stroms I für eine Schaltvorrichtung 1, welche zwei Schaltmodule 10 umfasst. In dem Diagramm der Fig. 4 wird von einer Nennspannung von 6 kV und einem Strom von 500 A ausgegangen. Die quell- und lastseitige Induktivität beträgt im gezeigten Ausführungsbeispiel jeweils 10 mH. Es ist gut zu erkennen, dass zu einem Zeitpunkt t = 10 ms die Auftrennung des Strompfads erfolgt. Bis zu diesem Zeitpunkt beträgt der Strom konstant I = 500 A. Die Spannung U, welche über der Steuervorrichtung 1 vor dem Abschalten abfällt, wird durch die Durchlassverluste des steuerbaren Halbleiterschaltelements 13 bestimmt. Durch das Abschalten zum Zeitpunkt t = 10 ms steigt die Spannung auf etwa 10 kV an. Durch das getaktete Aus- und Einschalten des steuerbaren Halbleiterschaltelements ergibt sich bis zum Zeitpunkt t = 15 ms ein zwischen 4,5 kV und 9 kV pendelnder Verlauf, wobei der Strom I durch die Gegenspannung von etwa 8 kV innerhalb von 5 ms (t = 15 ms - 10 ms) abgebaut wird. Danach wird die obere Schaltschwelle für das Takten des steuerbaren Halbleiterschaltelements nicht mehr erreicht, weswegen das steuerbare Halbleiterschaltelement dauerhaft sperrend geschaltet ist. Infolgedessen schwingt das System mit der Eigenresonanz aus. Der Strom hat sich zwischen t = 10 ms und t = 15 ms von 500 A auf 0 A abgebaut, wobei der Strom ebenfalls mit der Eigenresonanz ausschwingt.

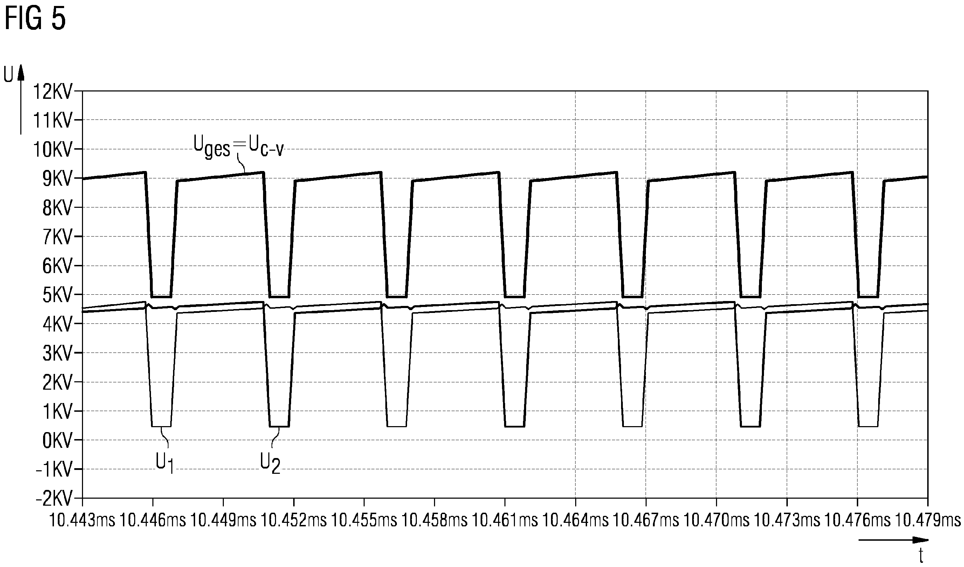

Fig. 5 zeigt ein Diagramm, in dem der zeitliche Verlauf der Spannungen bei einem Abschaltvorgang einer Schaltvorrichtung 1 mit zwei in Serie verschalteten Schaltmodulen in höherer zeitlicher Auflösung gezeigt ist. Der sich über dem steuerbaren Halbleiterschaltelement des ersten Schaltmoduls ergebende Spannungsverlauf ist mit U₁, der sich über dem steuerbaren Halbleiterschaltelement des zweiten Schaltmoduls ergebende Spannungsverlauf ist mit U₂ bezeichnet. Die resultierende Gesamtspannung, die der Gegenspannung U_{c-v} entspricht, ist mit U_{ges} dargestellt. Durch den gezeigten Zeitausschnitt zwischen 10,443 ms und 10,479 ms wird gut das Takten der steuerbaren Halbleiterschaltelemente der beiden Schaltmodule ersichtlich. Auch bei der Gesamtspannung U_{ges} ist der getaktete Verlauf der Spannung gut erkennbar.

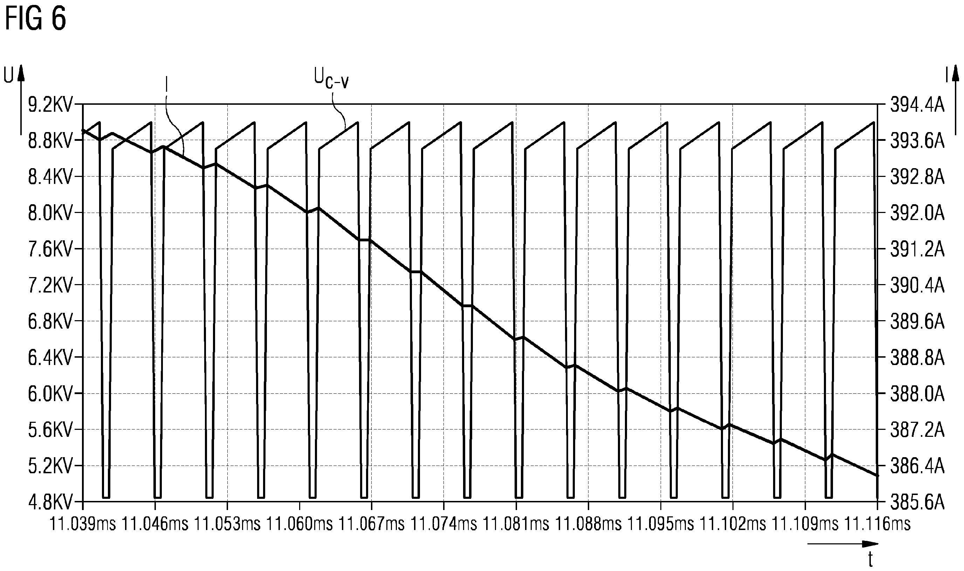

Fig. 6 zeigt den zeitlichen Verlauf einer durch die erfindungsgemäße Schaltvorrichtung erzeugten Gegenspannung U_{c-v} zusammen mit dem in dem Strompfad fließenden Strom I. Es ist gut erkennbar, dass durch das getaktete Ein- und Ausschalten der steuerbaren Halbleiterschaltelemente der Schaltmodule sich eine getaktete Gegenspannung U_{c-v} ergibt, welche zwischen 4,8 kV und 9 kV pendelt. In jedem Zeitabschnitt, in dem die Gegenspannung U_{c-v} eine hohe Gegenspannung zu der von der Gleichspannungsquelle gelieferten Spannung aufbaut, sinkt der durch den Strompfad I fließende Strom etwas ab. In den Phasen, in denen die steuerbaren Halbleiterschaltelemente leitend geschaltet sind, baut sich der Strom I wieder etwas auf. Aufgrund der im Vergleich geringeren Einschaltzeitdauer ergibt sich ein rampenförmig abfallender Strom.

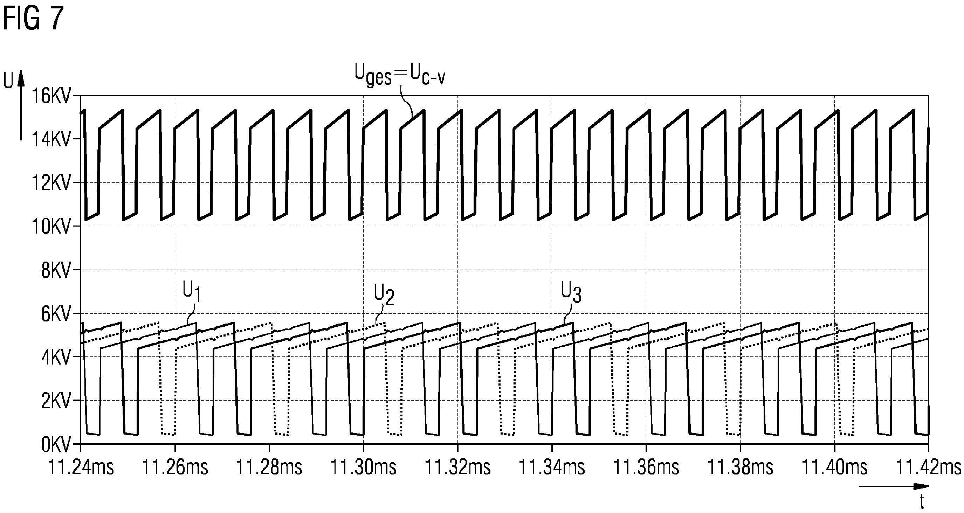

Fig. 7 zeigt den zeitlichen Verlauf der Modulspannungen U₁, U₂ und U₃ dreier in Serie verschalteter Schaltmodule. Mit U_{ges} ist wiederum die Gesamtspannung, welche der Gegenspannung U_{c-v} entspricht, dargestellt. Aus dieser Darstellung ist gut zu erkennen, dass zu einem gegebenen Zeitpunkt zumindest ein steuerbares Halbleiterschaltelement sperrend geschaltet ist. Weiterhin ist erkennbar, dass durch die Anzahl von n = 3 Schaltmodule die Schaltspannung im Vergleich zu einem Modul mit lediglich n = 2 Schaltmodulen (siehe Fig. 5) höher ist.

Allgemein kann durch die Erhöhung der Anzahl n der Schaltmodule die Schaltspannung weiter erhöht werden.

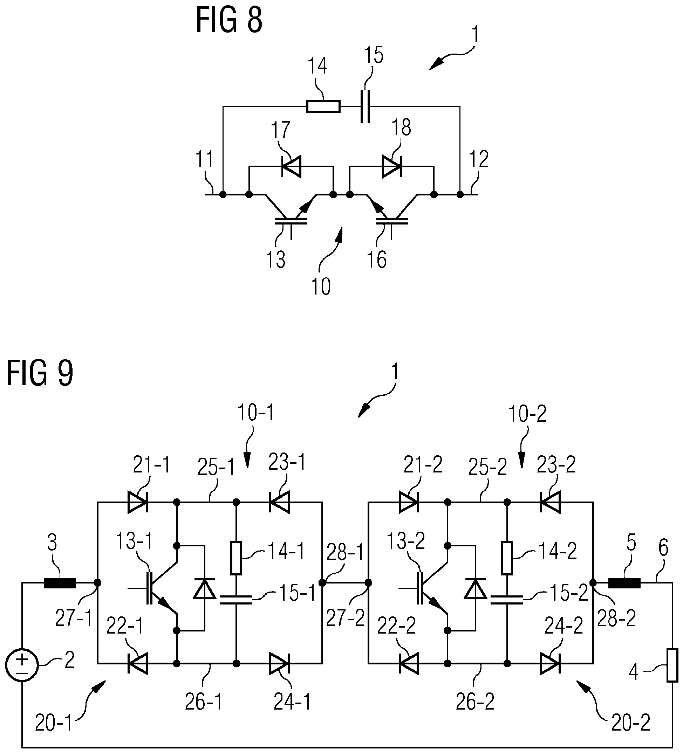

Fig. 8 zeigt eine Abwandlung des in Fig. 1 gezeigten Schaltmoduls 10. Zusätzlich zu dem Halbleiterschaltelement 13 ist ein weiteres Halbleiterschaltelement 16 anti-seriell zu dem steuerbaren Halbleiterschaltelement 13 verschaltet. Das steuerbare Halbleiterschaltelement 13 und das weitere steuerbare Halbleiterschaltelement 16 können vom gleichen Typ sein, z.B. IGBTs. Das Verhalten dieses bidirektional betreibbaren Schaltmoduls 10 entspricht dem Verhalten des Schaltmoduls aus Fig. 1. Der Stromfluss kann bei dem in Fig. 8 gezeigten bidirektionalen Schaltmodul 10 in beide Richtungen gerichtet sein. Dabei ist eines der beiden steuerbaren Halbleiterschaltelemente 13, 16 im leitenden Fall leitend und das andere sperrend geschaltet. Der Stromfluss wird über eine jeweilige anti-parallel geschaltete Diode 17 bzw. 18 gewährleistet.

Fig. 9 zeigt ein weiteres elektrisches Ersatzschaltbild einer erfindungsgemäßen Schaltvorrichtung 1, wobei diese exemplarisch zwei Schaltvorrichtungen 10-1 und 10-2 umfasst. Diese sind wie in Fig. 3 zwischen einer quellseitigen Induktivität 3 und einer lastseitigen Induktivität 5 verschaltet. Die Schaltmodule 10-1 und 10-2 (allgemein: 10-i, wobei i = 1 bis 2) sind in der Lage einen bidirektionalen Stromfluss zu verarbeiten. Hierzu ist ein wie in Fig. 1 gezeigtes Grundmodul in eine Gleichrichterbrücke 20-1 und 20-2 (allgemein: 20-i, wobei i = 1 bis 2) integriert. Der Aufbau wird anhand des Schaltmoduls 10-1 beschrieben, wobei der Aufbau des Schaltmoduls 10-2 identisch ist.

Die Gleichrichterbrücke 20-1 ist als Diodenbrücke mit vier Dioden 21-1, 22-1, 23-1 und 24-1 realisiert. Ein erster Gleichrichteranschluss 25-1 ist zwischen Kathoden der Dioden 21-1 und 23-1 gebildet. Ein zweiter Gleichrichteranschluss 26-1 ist zwischen Anodenanschlüssen der Dioden 22-1 und 24-1 gebildet. Das wie in Fig. 1 aufgebaute Schaltmodul ist zwischen dem ersten Gleichrichteranschluss 25-1 und dem zweiten Gleichrichteranschluss 26-1 verschaltet. Ein dritter Gleichrichteranschluss 27-1 ist zwischen der Anode der Diode 21-1 und der Kathode der Diode 22-1 ausgebildet. Der dritte Gleichrichteranschluss 27-1 ist über die quellseitige Induktivität 3 mit der Gleichspannungsquelle 2 verbunden. Ein vierter Gleichrichteranschluss 28-1 ist zwischen einer Anode der Diode 23-1 und einer Kathode der Diode 24-1 ausgebildet.

Der vierte Gleichrichteranschluss 28-1 ist mit dem ersten Gleichrichteranschluss 27-2 des zweiten Schaltmoduls 10-2 verschaltet.

In der Gleichrichterbrücke 20-1 ist somit ein unidirektionales Grundmodul angeordnet, welche zusammen das Schaltmodul 10-1 ergeben. Dieses wird für beide Stromrichtungen genutzt, wobei die Stromumkehr durch die Elemente der Gleichrichterbrücke 20-i realisiert wird. Der Einfachheit halber sind Fig. 9 lediglich die Gleichspannungsquelle 2 links und die Last 4 rechts von der Schaltvorrichtung 1 dargestellt. Für einen bidirektionalen Betrieb weist die Anordnung eine weitere Gleichspannungsquelle rechts und eine weitere Last 4 links von der Schaltvorrichtung 1 auf.

Wie in Fig. 9 gezeigt, können von den Schaltmodulen 10-i eine beliebige Anzahl in Reihe geschaltet werden.

## Patentansprüche

1. Schaltvorrichtung (1) zum Auftrennen eines quell- und lastseitige Induktivitäten (3, 5) umfassenden Strompfads (6) eines Gleichspannungsnetzes, umfassend zumindest zwei in Serie verschaltete Schaltmodule (10), wobei jedes der Schaltmodule (10) zumindest ein steuerbares Halbleiterschaltelement (13, 16) umfasst, dem eine Serienschaltung aus einem Widerstand (14) und einem Kondensator (15) parallel geschaltet ist, **dadurch gekennzeichnet, dass** die Schaltvorrichtung eingerichtet ist, die steuerbaren Halbleiterschaltelemente (13, 16) im Betrieb der Schaltvorrichtung zum Auftrennen des Strompfads (6) bis zum Abbau der in den Induktivitäten (3, 5) gespeicherten Energie jeweils abwechselnd ein- und wieder auszuschalten, wobei Halbleiterschaltelemente unterschiedlicher Schaltmodule (10) zu unterschiedlichen Zeitpunkten ein- und ausgeschaltet werden, sodass sich zu einem gegebenen Zeitpunkt zumindest ein Schaltmodul in einem sperrenden Zustand befindet.

2. Schaltvorrichtung nach Anspruch 1,
**dadurch gekennzeichnet, dass** die Parallelschaltung aus dem zumindest einen steuerbaren Halbleiterschaltelement (13, 16) und der Serienschaltung aus dem Widerstand (14) und dem Kondensator (15) zwischen einem ersten Schaltmodulanschluss (11) und einem zweiten Schaltmodulanschluss (12) des jeweiligen Schaltmoduls (10) verschaltet ist.

3. Schaltvorrichtung nach Anspruch 1,
**dadurch gekennzeichnet, dass** die Parallelschaltung aus dem zumindest einen steuerbaren Halbleiterschaltelement (13, 16) und der Serienschaltung aus dem Widerstand (14) und dem Kondensator (15) zwischen einem ersten Gleichrichtanschluss (25) und einem zweiten Gleichrichtanschluss (26) einer Gleichrichterbrücke (20) des jeweiligen Schaltmoduls (10) verschaltet ist, wobei der erste Gleichrichtanschluss (25) ein erster Knotenpunkt der Gleichrichterbrücke (20) ist, an dem Kathodenanschlüsse zweier Gleichrichtelemente (21, 23) miteinander verschaltet sind, und wobei der zweite Gleichrichtanschluss (26) ein zweiter Knotenpunkt (26) der Gleichrichterbrücke (20) ist, an dem Anodenanschlüsse zweier weiterer Gleichrichtelemente (22, 24) miteinander verschaltet sind.

4. Schaltvorrichtung nach einem der vorhergehenden Ansprüche, **dadurch gekennzeichnet, dass** im Betrieb der Schaltvorrichtung (1) zum Auftrennen des Strompfads (6) bis zum Abbau der in den Induktivitäten (3, 5) gespeicherten Energie zu einem gegebenen Zeitpunkt das steuerbare Halbleiterschaltelement (13, 16) zumindest eines Schaltmoduls (10) sperrend geschaltet ist.

5. Schaltvorrichtung nach einem der vorhergehenden Ansprüche, **dadurch gekennzeichnet, dass** im Betrieb der Schaltvorrichtung zum Auftrennen des Strompfads (6) bis zum Abbau der in den Induktivitäten (3, 5) gespeicherten Energie zu einem gegebenen Zeitpunkt das steuerbare Halbleiterschaltelement (13, 16) einer ersten Teilanzahl von Schaltmodulen (10) sperrend geschaltet und eine zweite Teilanzahl von Schaltmodulen (10) leitend geschaltet ist.

6. Schaltvorrichtung nach einem der vorhergehenden Ansprüche, **dadurch gekennzeichnet, dass** im Betrieb der Schaltvorrichtung zum Auftrennen des Strompfads (6) bis zum Abbau der in den Induktivitäten (3, 5) gespeicherten Energie das steuerbare Halbleiterschaltelement (13, 16) des- oder derjenigen Schaltmodule (10) leitend geschaltet wird, über dessen oder deren Kondensator (15) die Spannung einen vorgegebenen oberen Schwellwert erreicht.

7. Schaltvorrichtung nach einem der vorhergehenden Ansprüche, **dadurch gekennzeichnet, dass** im Betrieb der Schaltvorrichtung zum Auftrennen des Strompfads (6) bis zum Abbau der in den Induktivitäten (3, 5) gespeicherten Energie das steuerbare Halbleiterschaltelement (13, 16) des- oder derjenigen Schaltmodule (10) sperrend geschaltet wird, über dessen oder deren Kondensator (15) die Spannung einen vorgegebenen unteren Schwellwert erreicht.

8. Schaltvorrichtung nach einem der vorhergehenden Ansprüche, **dadurch gekennzeichnet, dass** im Betrieb der Schaltvorrichtung zum Auftrennen des Strompfads (6) bis zum Abbau der in den Induktivitäten (3, 5) gespeicherten Energie das steuerbare Halbleiterschaltelement (13, 16) des- oder derjenigen Schaltmodule (10) dauerhaft sperrend geschaltet wird, wenn über dessen oder deren Kondensator (15) die Spannung den vorgegebenen Schwellwert nicht mehr erreicht.

9. Schaltvorrichtung nach einem der vorhergehenden Ansprüche, **dadurch gekennzeichnet, dass** im Betrieb der Schaltvorrichtung zum Auftrennen des Strompfads (6) bis zum Abbau der in den Induktivitäten (3, 5) gespeicherten Energie zu einem gegebenen Zeitpunkt das steuerbare Halbleiterschaltelement (13, 16) des Schaltmoduls (10) leitend geschaltet wird, über deren Kondensator (15) die höchste Spannung im Vergleich zu den Spannungen der Kondensatoren (15) der übrigen Schaltmodule (10) anliegt.

10. Schaltvorrichtung nach einem der vorhergehenden Ansprüche,
**dadurch gekennzeichnet, dass** in dem Pfad des steuerbaren Halbleiterschaltelements eines jeweiligen Schaltmoduls (10) ein weiteres steuerbares Halbleiterschaltelement (13, 16) anti-seriell zu dem steuerbaren Halbleiterschaltelement (13, 16) verschaltet ist.

11. Schaltvorrichtung nach einem der vorhergehenden Ansprüche,
**dadurch gekennzeichnet, dass** das steuerbare Halbleiterschaltelement (13, 16) ein abschaltbares Halbleiterschaltelement (13, 16), insbesondere ein IGBT, ein MOSFET, ein IGCT oder ein Thyristor mit einer Abschaltvorrichtung, ist.

12. Schaltvorrichtung nach einem der vorhergehenden Ansprüche,
**dadurch gekennzeichnet, dass** diese für die Verwendung in einem Gleichspannungsnetz mit einer Spannung von mehr als 1000 V vorgesehen ist.

13. Verwendung der Schaltvorrichtung gemäß einem der vorhergehenden Ansprüche als kurzschlussfester Leistungsschalter.

## Claims

1. Switching device (1) for disconnecting a current path (6) in a DC supply system, said current path (6) comprising inductances (3, 5) at the source end and the load end, which comprises at least two series-connected switching modules (10), wherein each of the switching modules (10) comprises at least one controllable semiconductor switching element (13, 16), to which a series circuit consisting of a resistor (14) and a capacitor (15) is connected in parallel, **characterized in that**, in the operation of the switching device for disconnecting the current path (6), pending the clearance of the energy stored in the inductances (3, 5), the switching device is configured to respectively switch the controllable semiconductor switching elements on and off again in an alternating manner, wherein semiconductor switching elements of different switching modules (10) are switched on and off at different time points, with the result that at least one switching module is in a blocking state at any given time point.

2. Switching device according to Claim 1,
**characterized in that** the parallel-connected arrangement of the at least one controllable semiconductor switching element (13, 16) and the series-connected arrangement of the resistor (14) and the capacitor (15) is interconnected between a first switching module terminal (11) and a second switching module terminal (12) of the respective switching module (10).

3. Switching device according to Claim 1,
**characterized in that** the parallel-connected arrangement of the at least one controllable semiconductor switching element (13, 16) and the series-connected arrangement of the resistor (14) and the capacitor (15) is interconnected between a first rectifier terminal (25) and a second rectifier terminal (26) of a rectifier bridge (20) of the respective switching module (10), wherein the first rectifier terminal (25) is a first node point of the rectifier bridge (20), on which cathode terminals of two rectifier components (21, 23) are mutually interconnected, and wherein the second rectifier terminal (26) is a second node point (26) of the rectifier bridge (20), on which anode terminals of two further rectifier components (22, 24) are mutually interconnected.

4. Switching device according to one of the preceding claims, **characterized in that**, in the operation of the switching device (1) for disconnecting the current path (6), pending the clearance of the energy stored in the inductances (3, 5), at a given time point, the controllable semiconductor switching element (13, 16) of at least one switching module (10) is switched to a blocking state.

5. Switching device according to one of the preceding claims, **characterized in that**, in the operation of the switching device for disconnecting the current path (6), pending the clearance of the energy stored in the inductances (3, 5), at a given time point, the controllable semiconductor switching element (13, 16) of a first partial number of switching modules (10) is switched to a blocking state, and a second partial number of switching modules (10) is switched to a conducting state.

6. Switching device according to one of the preceding claims, **characterized in that**, in the operation of the switching device for disconnecting the current path (6), pending the clearance of the energy stored in the inductances (3, 5), the controllable semiconductor switching element (13, 16) of that or those switching module(s) (10) is switched to a conducting state, across the capacitor(s) (15) of which the voltage achieves a predefined upper threshold value.

7. Switching device according to one of the preceding claims, **characterized in that**, in the operation of the switching device for disconnecting the current path (6), pending the clearance of the energy stored in the inductances (3, 5), the controllable semiconductor switching element (13, 16) of that or those switching module(s) (10) is switched to a blocking state, across the capacitor(s) (15) of which the voltage achieves a predefined lower threshold value.

8. Switching device according to one of the preceding claims, **characterized in that**, in the operation of the switching device for disconnecting the current path (6), pending the clearance of the energy stored in the inductances (3, 5), the controllable semiconductor switching element (13, 16) of that or those switching module(s) (10) is permanently switched to a blocking state, if, via the capacitor(s) (15) thereof, the voltage no longer achieves the predefined threshold value.

9. Switching device according to one of the preceding claims, **characterized in that**, in the operation of the switching device for disconnecting the current path (6), pending the clearance of the energy stored in the inductances (3, 5), at a given time point, the controllable semiconductor switching element (13, 16) of the switching module (10) is switched to a conducting state, on the capacitor (15) of which the highest voltage is present, in comparison with the voltages on the capacitors (15) of the remaining switching modules (10).

10. Switching device according to one of the preceding claims, **characterized in that**, in the path of the controllable semiconductor switching element of a respective switching module (10), a further controllable semiconductor switching element (13, 16) is interconnected in an anti-series arrangement with the controllable semiconductor switching element (13, 16) .

11. Switching device according to one of the preceding claims, **characterized in that** the controllable semiconductor switching element (13, 16) is an interruptible semiconductor switching element (13, 16), specifically an IGBT, a MOSFET, an IGCT or a thyristor having a cut-off device.

12. Switching device according to one of the preceding claims, **characterized in that** the latter is provided for use in a DC supply system having a voltage greater than 1,000 V.

13. Application of the switching device according to one of the preceding claims as a short-circuit-proof power switch.

## Revendications

1. Dispositif (1) de coupure pour la séparation d'un chemin (6) de courant, comprenant des inductances (3, 5) du côté de la source (6) et du côté de la charge, d'un réseau à tension continue comprenant au moins deux modules (10) de coupure montés en série, dans lequel chacun des modules (10) de coupure comprend au moins un élément (13, 16) de coupure à semi-conducteur pouvant être commandé, en parallèle duquel est monté un circuit série composé d'une résistance (14) et d'un condensateur (15), **caractérisé en ce que** le dispositif de coupure est agencé pour en alternance mettre à l'état de conduction et remettre à l'état de non conduction les éléments (13, 16) de coupure à semi-conducteur pouvant être commandés, alors que le dispositif de coupure est en fonctionnement pour la séparation du chemin (6) de courant jusqu'à la dissipation de l'énergie emmagasinée dans les inductances (3, 5), dans lequel des éléments de coupure à semi-conducteur de module (10) de coupure différents sont mis à l'état de conduction et remis à l'état de non conduction à des instants différents de manière à ce qu'à un instant donné, au moins un module de coupure se trouve dans un état de non conduction.

2. Dispositif de coupure suivant la revendication 1, **caractérisé en ce que** le circuit parallèle, composé d'au moins un élément (13, 16) de coupure à semi-conducteur pouvant être commandé, et le circuit série, composé de la résistance (14) et du condensateur (15), est monté entre une première borne (11) de module de coupure et une deuxième borne (12) de module de coupure du module (10) de coupure respectif.

3. Dispositif de coupure suivant la revendication 1, **caractérisé en ce que** le circuit parallèle composé d'au moins un élément (13, 16) de coupe à semi-conducteur pouvant être commandé, et le circuit série, composé de la résistance (14) et du condensateur (15), est monté entre une première borne (25) de redressement et une deuxième borne (26) de redressement d'un pont (20) redresseur du module (10) respectif de coupure, dans lequel la première borne (25) de redressement est un premier point nodal du pont (20) redresseur, où des bornes de cathode de deux éléments (21, 23) redresseurs sont reliées entre elles, et dans lequel la deuxième borne (26) de redressement est un deuxième point (26) nodal du pont (20) redresseur, où des bornes d'anode de deux autres éléments (22, 24) redresseurs sont reliées entre elles.

4. Dispositif de coupure suivant l'une des revendications précédentes,
**caractérisé en ce que**, lorsque le dispositif (1) de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé d'au moins un élément (10) de coupure est monté dans un état de non conduction.

5. Dispositif de coupure suivant l'une des revendications précédentes,
**caractérisé en ce que**, lorsque le dispositif de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé d'un premier nombre partiel de modules (10) de coupure est monté dans un état de non conduction et un deuxième nombre partiel de modules (10) de coupure est monté à l'état de conduction.

6. Dispositif de coupure suivant l'une des revendications précédentes,
**caractérisé en ce que**, lorsque le dispositif de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé du ou des modules (10) de coupure, dont la tension aux bornes de son ou de ses condensateurs (15) atteint une valeur de seuil supérieure donnée à l'avance, est monté à l'état de non conduction.

7. Dispositif de coupure suivant l'une des revendications précédentes,
**caractérisé en ce que**, lorsque le dispositif de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé du ou des modules (10) de coupure, dont la tension aux bornes de son ou de ses condensateurs (15) atteint une valeur de seuil inférieure donnée à l'avance, est monté à l'état de conduction.

8. Dispositif de coupure suivant l'une des revendications précédentes,
**caractérisé en ce que** lorsque le dispositif de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé du ou des modules (10) de coupure est monté à l'état de non conduction d'une manière permanente, si la tension aux bornes de son ou de ses condensateurs (15) n'atteint plus la valeur de seuil donnée à l'avance.

9. Dispositif de coupure suivant l'une des revendications précédentes,
**caractérisé en ce que** lorsque le dispositif de coupure est en fonctionnement pour la séparation du chemin (6) de courant jusqu'à la dissipation de l'énergie emmagasinée dans les inductances (3, 5) à un instant donné, l'élément (13, 16) de coupure à semi-conducteur pouvant être commandé du module (10) de coupure, dont la tension aux bornes du condensateur (15) est la plus haute par rapport aux tensions aux bornes des condensateurs (15) des autres modules (10) de coupure, est monté à l'état de conduction.

10. Dispositif de coupure suivant l'une des revendications précédentes,
**caractérisé en ce que**, dans le chemin de l'élément de coupure à semi-conducteur pouvant être commandé d'un module (10) de coupure respectif, un autre élément (13, 16) de coupure à semi-conducteur pouvant être commandé est monté tête bêche avec l'élément (13, 16) de coupure à semi-conducteur pouvant être commandé.

11. Dispositif de coupure suivant l'une des revendications précédentes,
**caractérisé en ce que** l'élément (13, 16) de coupure à semi-conducteur pouvant être commandé est un élément (13, 16) de coupure à semi-conducteur pouvant être mis à l'état de non conduction, en particulier un IGBT, un MOSFET, un IGCT ou un thyristor ayant un dispositif de mise à l'état de non conduction.

12. Dispositif de coupure suivant l'une des revendications précédentes,
**caractérisé en ce que** celui-ci est prévu pour l'utilisation, dans un réseau à tension continue, d'une tension de plus de 1000 V.

13. Utilisation du dispositif de coupure suivant l'une des revendications précédentes comme disjoncteur résistant au court-circuit.
